# EUROPÄISCHE PATENTSCHRIFT

(11) **EP 2 436 058 B1**
(45) Veröffentlichungstag und Bekanntmachung des Hinweises auf die Patenterteilung: **19.09.2018**
(21) Anmeldenummer: 10720434.9
(22) Anmeldetag: 27.05.2010
(51) Int. Cl.: H01L 51/52

(54) **ORGANISCHE LEUCHTDIODE**
ORGANIC LIGHT-EMITTING DIODE
DIODE LUMINESCENTE ORGANIQUE

(30) Priorität: 29.05.2009 DE 102009023352; 12.08.2009 DE 102009037185
(43) Veröffentlichungstag der Anmeldung: 04.04.2012
(73) Patentinhaber: OSRAM OLED GmbH, 93049 Regensburg (DE)
(72) Erfinder: FRISCHEISEN, Jörg, 86830 Schwabmünchen (DE); NOWY, Stefan, 86830 Schwabmünchen (DE); BRÜTTING, Wolfgang, 86159 Augsburg (DE)
(74) Vertreter: Epping - Hermann - Fischer
(86) Internationale Anmeldenummer: PCT/EP2010/057346
(87) Internationale Veröffentlichungsnummer: WO 2010/136537

(56) Entgegenhaltungen:
- DE-A1-102008 022 830
- US-A1- 2006 103 321
- KUN-CHENG TIEN AND CHUNG-CHIH WU DEPARTMENT OF ELECTRICAL ENGINEERING ET AL: "P-162: Recycling Surface Plasmon Polaritons of OLED for Tunable Double Emission and Efficiency Enhancement" SID 2007, 2007 SID INTERNATIONAL SYMPOSIUM, SOCIETY FOR INFORMATION DISPLAY, LOS ANGELES, USA, Bd. XXXVIII, 20. Mai 2007 (2007-05-20), Seiten 806-811, XP007013484 ISSN: 0007-966X
- WEDGE S ET AL: "Coupled surface plasmon-polariton mediated photoluminescence from a top-emitting organic light-emitting structure" APPLIED PHYSICS LETTERS, AIP, AMERICAN INSTITUTE OF PHYSICS, MELVILLE, NY, US LNKD- DOI:10.1063/1.1772516, Bd. 85, Nr. 2, 1. Januar 2004 (2004-01-01) , Seiten 182-184, XP012063335 ISSN: 0003-6951
- LUPTON JOHN M ET AL: "Bragg scattering from periodically microstructured light emitting diodes" APPLIED PHYSICS LETTERS, AIP, AMERICAN INSTITUTE OF PHYSICS, MELVILLE, NY, US LNKD- DOI:10.1063/1.1320023, Bd. 77, Nr. 21, 20. November 2000 (2000-11-20), Seiten 3340-3342, XP012026694 ISSN: 0003-6951
- S. NOWY, N.A. REINKE, J. FRISCHEISEN, W. BRÜTTING: "Light extraction and optical loss mechanisms in organic light-emitting diodes" ORGANIC OPTOELECTRONICS AND PHOTONICS, PROC. OF SPIE, Bd. 6999, 16. April 2008 (2008-04-16), Seiten 1-11, XP002593603
- CHEN C-W ET AL: "TOP-EMITTING ORGANIC LIGHT-EMITTING DEVICES USING SURFACE-MODIFIED AG ANODE", APPLIED PHYSICS LETTERS, A I P PUBLISHING LLC, US, vol. 83, no. 25, 22 December 2003 (2003-12-22), pages 5127-5129, XP001195154, ISSN: 0003-6951, DOI: 10.1063/1.1635076
- RIEL H ET AL: "Tuning the emission characteristics of top-emitting organic light-emitting devices by means of a dielectric capping layer: An experimental and theoretical study", JOURNAL OF APPLIED PHYSICS, AMERICAN INSTITUTE OF PHYSICS, US, vol. 94, no. 8, 15 October 2003 (2003-10-15), pages 5290-5296, XP012060416, ISSN: 0021-8979, DOI: 10.1063/1.1605256
- BERT J SCHOLZ ET AL: "Extraction of surface plasmons in organic light-emitting diodes via high-index coupling", OPTICS EXPRESS, vol. 20 Suppl 2, no. S2, 12 March 2012 (2012-03-12), pages A205-11004, XP055460635, US ISSN: 1094-4087, DOI: 10.1364/OE.20.00A205

## Beschreibung

Es wird eine organische Leuchtdiode angegeben.
Die Druckschrift DE 10 2008 022 830 A1 betrifft ein strahlungsemittierendes Bauelement.
In der Druckschrift Kun-Cheng Tien et al. in SID DIGEST, 2007, Seiten 806 bis 809, ist eine OLED angegeben, bei der Oberflächenplasmonen zur Strahlungserzeugung verwendet werden.
In der Druckschrift S. Wedge et al. in Applied Physics Letters, Bd. 85, 2004, Seiten 182 bis 184, ist eine durch Oberflächenplasmonen vermittelte Photolumineszenz beschrieben.
Die Druckschrift John M. Lupton et al. in Applied Physics Letters, Bd. 77, 2000, Seiten 3340 bis 3342, betrifft eine Leuchtdiode mit einer Bragg-Strukturierung.
Ein elektrolumineszierendes Bauteil mit einer transparenten Elektrode findet sich in der Druckschrift US 2006/0103321 A1. Die Druckschriften Hen C-W et al., "TOP-EMITTING ORGANIC LIGHT-EMITTING DEVICES USING SURFACE-MODIFIED AG ANODE", APPLIED PHYSICS LETTERS, Bd. 83, Nr. 25, 22. Dezember 2003, Seiten 5127-5129, DOI: 10.1063/1.1635076, sowie Riel H et al., "Tuning the emission characteristics of top-emitting organic light-emitting devices by means of a dielectric capping layer: An experimental and theoretical study", JOURNAL OF APPLIED PHYSICS, Bd. 94, Nr. 8, 15, Oktober 2003, Seiten 5290-5296, DOI: 10.1063/1.1605256, betreffen organische Leuchtdioden mit Antireflexschichten.
Eine zu lösende Aufgabe besteht darin, eine organische Leuchtdiode, kurz OLED, anzugeben, bei der Licht effizient aus Plasmonenmoden einer Metallelektrode auskoppelbar ist. Diese Aufgabe wird gelöst durch eine Leuchtdiode mit den Merkmalen des unabhängigen Patentanspruchs.

Die organische Leuchtdiode gemäß der Erfindung umfasst eine erste Elektrode, die mit einem Metall gebildet ist. Beispielsweise besteht die erste Elektrode aus Silber, Aluminium, Kadmium, Barium, Indium, Magnesium, Kalzium, Lithium und/oder Gold. Die erste Elektrode ist also insbesondere mit einem elektrisch leitfähigen Material gestaltet, das auch im Falle dünner Schichten lichtundurchlässig ist. Mit anderen Worten ist die erste Elektrode bevorzugt mit einem Material gestaltet, das, wenn es in einer Dicke von mindestens einem Viertel einer Vakuum-Wellenlänge einer Strahlung im sichtbaren Spektralbereich vorliegt, für diese Strahlung undurchlässig ist.

Die organische Leuchtdiode gemäß der Erfindung umfasst mindestens eine organische Schichtenfolge mit wenigstens einer aktiven Schicht. Die aktive Schicht ist hierbei zur Erzeugung einer elektromagnetischen Strahlung eingerichtet. Die aktive Schicht basiert beispielsweise auf einem organischen Polymer, auf einem organischen Oligomer, auf organischen Monomeren, auf organischen kleinen, nicht-polymeren Molekülen oder auf einer Kombination hieraus. Die organische Schichtenfolge kann weitere organische Schichten aufweisen, die zum Beispiel als Ladungsträgerinjektionsschichten, als Ladungsträgertransportschichten und/oder als Ladungsträgerstoppschichten ausgestaltet sind.

Die organische Leuchtdiode gemäß der Erfindung weist eine zweite Elektrode auf. Bevorzugt ist die zweite Elektrode, wie auch die erste Elektrode, flächig und/oder planar gestaltet. Flächig kann bedeuten, dass die Elektroden Hauptflächen der organischen Schichtenfolge an voneinander abgewandten Seiten zu mindestens 80 % oder vollständig bedecken, oder dass ein Verhältnis aus lateraler Ausdehnung und Dicke der Elektroden mindestens 1000 beträgt.

Bei der organischen Leuchtdiode gemäß der Erfindung befindet sich die organische Schichtenfolge zwischen der ersten und der zweiten Elektrode. Die organische Schichtenfolge kann sich hierbei vollständig oder teilweise zwischen den Elektroden befinden.

Die organische Leuchtdiode gemäß der Erfindung umfasst eine strahlungsdurchlässige Indexschicht. Die Indexschicht ist also mindestens in Teilbereichen des sichtbaren Spektralbereichs transparent und klarsichtig gestaltet. Weiterhin ist die Indexschicht mit einem dielektrischen Material gestaltet. Die Indexschicht kann hierbei mit einem homogenen, beispielsweise kristallinen Material geformt sein oder auch durch wenigstens ein Metamaterial gebildet sein. Weist die Indexschicht ein kristallines Material auf, so sind geeignete Materialien zum Beispiel LiNbO₃, ZnS, ZnSe oder TeO₂. Ebenso können organische Materialien, wie C₆₀ mit einem Brechungsindex von zirka 2,2, für die oder in der Indexschicht verwendet werden.

Ein geeignetes Metamaterial ist zum Beispiel TiO₂, das in einem Matrixmaterial eingebettet ist. Geeignete Matrixmaterialien sind beispielsweise Polymere, insbesondere Epoxide, Silikone und Epoxid-Silikon-Hybridmaterialien.

Bei der organischen Leuchtdiode gemäß der Erfindung ist die Indexschicht an einer der organischen Schichtenfolge abgewandten Außenseite der ersten Elektrode aufgebracht. Mit anderen Worten befindet sich zwischen der Indexschicht und der organischen Schichtenfolge die metallische erste Elektrode.

Bei der organischen Leuchtdiode gemäß der Erfindung ist ein mittlerer optischer Brechungsindex der Indexschicht größer als ein mittlerer Brechungsindex der organischen Schichtenfolge. Mittlerer Brechungsindex bedeutet hierbei, dass der Brechungsindex über die gesamte Schichtdicke der organischen Schichtenfolge beziehungsweise der Indexschicht gemittelt wird, wobei Schichten der Indexschicht, die sich näher an der ersten Elektrode befinden, aufgrund des exponentiellen Abklingens von Plasmonenmode in einer Richtung weg von der ersten Elektrode, stärker gewichtet werden können. Es kann der mittlere Brechungsindex auch ein effektiver Brechungsindex der jeweiligen Schichten sein. Beträgt beispielsweise der mittlere und/oder effektive Brechungsindex der organischen Schichtenfolge 1,8, so beträgt der mittlere und/oder effektive Brechungsindex der Indexschicht mindestens ein 1,2 -faches davon.

Die organische Leuchtdiode gemäß der Erfindung weist eine Vorderseite und eine Rückseite auf. Die Rückseite ist hierbei der Indexschicht zugewandt oder durch die Indexschicht gebildet, und die Vorderseite ist der organischen Schichtenfolge zugewandt. Das heißt, zwischen der Rückseite und der organischen Schichtenfolge befindet sich mindestens zum Teil die Indexschicht und zwischen der Vorderseite und der Indexschicht befindet sich mindestens teilweise die organische Schichtenfolge. Eine in der Leuchtdiode erzeugte Strahlung verlässt die organische Leuchtdiode an der Vorderseite und/oder an der Rückseite. Bevorzugt verlässt die Strahlung die Leuchtdiode mindestens an der Vorderseite und optional zusätzlich an der Rückseite. An Seitenflächen quer zur Vorderseite der Leuchtdiode wird bevorzugt kein oder kein signifikanter Strahlungsanteil emittiert.

Bei der organischen Leuchtdiode gemäß der Erfindung durchläuft mindestens ein Teil einer von der organischen Leuchtdiode erzeugten elektromagnetischen Plasmonenstrahlung die Indexschicht. Die Plasmonenstrahlung ist hierbei eine Strahlung, die aus Oberflächenplasmonen mindestens der ersten Elektrode generiert ist.

Die organische Leuchtdiode gemäß der Erfindung umfasst eine erste Elektrode, die mit einem Metall gebildet ist, und eine zweite Elektrode. Weiterhin beinhaltet die organische Leuchtdiode eine organische Schichtenfolge mit mindestens einer aktiven Schicht, wobei sich die organische Schichtenfolge zwischen der ersten und der zweiten Elektrode befindet. Außerdem weist die organische Leuchtdiode eine Strahlung durchlässige Indexschicht auf, die sich an einer der organischen Schichtenfolge abgewandten Außenseite der ersten Elektrode befindet. Ein mittlerer Brechungsindex der Indexschicht ist hierbei größer als ein mittlerer Brechungsindex der organischen Schichtenfolge. Weiterhin weist die organische Leuchtdiode eine Vorderseite und eine Rückseite auf, wobei die Rückseite der Indexschicht und die Vorderseite der organischen Schichtenfolge zugewandt ist und eine in der Leuchtdiode erzeugte Strahlung an der Vorderseite und/oder an der Rückseite emittiert wird. Mindestens ein Teil einer von der organischen Leuchtdiode erzeugten elektromagnetischen Plasmonenstrahlung durchläuft die Indexschicht.
Gemäß zumindest einer Ausführungsform befindet sich die erste Elektrode in direktem physischen Kontakt sowohl zur organischen Schichtenfolge als auch zur Indexschicht. Mit anderen Worten ist die erste Elektrode in einer Richtung quer zu einer Haupterstreckungsrichtung der ersten Elektrode von der Indexschicht und der organischen Schichtenfolge vollständig oder teilweise begrenzt und eingeschlossen.

Bei der organischen Leuchtdiode gemäß der Erfindung sind durch eine in der aktiven Schicht erzeugte elektromagnetische Strahlung mindestens an der Grenzfläche zwischen der ersten Elektrode und der organischen Schichtenfolge Oberflächenplasmonen angeregt. Durch diese Oberflächenplasmonen ist die Plasmonenstrahlung vollständig oder teilweise erzeugt.
Die zur Strahlungserzeugung vorgesehene aktive Schicht der organischen Schichtenfolge weist im Regelfall Moleküle auf, die in einem elektronisch angeregten Zustand näherungsweise ein elektrisches Dipolmoment aufzeigen, wobei in einem elektronischen Grundzustand die Moleküle kein Dipolmoment aufzuzeigen brauchen. Weiterhin existieren an der Grenzfläche zwischen der organischen Schichtenfolge und der metallischen ersten Elektrode elektromagnetische Grenzflächenmoden. Über Nahfeldeffekte und/oder über Oberflächenrauheiten können die Grenzflächenmoden, auch als Oberfächenplasmonenmoden bezeichnet, an die Moleküle der organischen Schichtenfolge koppeln oder umgekehrt. Gemessen an einer gesamten von der aktiven Schicht generierten Lichtmenge kann die Größenordnung des Ausmaßes der Ankopplung an die Oberflächenplasmonenmoden zirka 30 % betragen. Mit anderen Worten geht ein erheblicher Leistungsanteil der organischen Leuchtdiode an die Oberflächenplasmonen über.
Bei einer organischen Leuchtdiode, die nicht über eine wie beschrieben gestaltete Indexschicht verfügt, geht der an die Oberflächenplasmonen gekoppelte Leistungsanteil, insbesondere durch Dämpfung der Oberflächenplasmonenmoden im Metall der ersten Elektrode, verloren und ist nicht in Licht umwandelbar. Durch die Indexschicht an der der organischen Schichtenfolge abgewandten Seite der ersten Elektrode ist eine Energieerhaltung und eine Impulserhaltung für die Umwandlung der Oberflächenplasmonen in elektromagnetische Strahlung erfüllbar. Es ist also ermöglicht, dass die Oberflächenplasmonen mindestens zum Teil an der Außenseite der ersten Elektrode in elektromagnetische Strahlung umgewandelt werden.
Diese Strahlung, die Plasmonenstrahlung, generiert aus den Oberflächenplasmonen der ersten Elektrode, durchläuft dann wenigstens zum Teil die Indexschicht und tritt beispielsweise an der Rückseite der organischen Leuchtdiode, die etwa durch die Indexschicht gebildet ist, aus der organischen Leuchtdiode aus. Durch die Rückumwandlung der Oberflächenplasmonen in der ersten Elektrode in elektromagnetische Strahlung sind ein Wirkungsgrad und eine Effizienz der organischen Leuchtdiode steigerbar.

Bei der organischen Leuchtdiode gemäß der Erfindung weist die Indexschicht eine mittlere geometrische Dicke von mindestens 200 nm auf. Bevorzugt übersteigt die mittlere geometrische Dicke der Indexschicht mindestens 300 nm, insbesondere mindestens 500 nm. Die Indexschicht weist also eine Dicke auf, die mindestens der Größenordnung der Wellenlänge der elektromagnetischen Strahlung innerhalb der Indexschicht entspricht.
Gemäß zumindest einer Ausführungsform der organischen Leuchtdiode weist die erste metallische Elektrode eine Dicke zwischen einschließlich 15 nm und 65 nm auf, bevorzugt zwischen einschließlich 25 nm und 50 nm. Bei einer Dicke der ersten Elektrode in dem angegebenen Bereich ist die erste Elektrode weitestgehend Strahlung undurchlässig. Das heißt, kein signifikanter Anteil der in der aktiven Schicht erzeugten Strahlung durchläuft die erste Elektrode direkt, ohne reflektiert, absorbiert oder in Oberflächenplasmonen umgewandelt zu werden. Andererseits ist die Dicke der ersten Elektrode in dem angegebenen Bereich hinreichend gering, um einen Transport der Oberflächenplasmonen von einer der organischen Schichtenfolge zugewandten Innenseite der ersten Elektrode an die Außenseite der ersten Elektrode effizient zu gewährleisten. In dem angegebenen Dickenbereich der ersten Elektrode ist die Generierung der Plasmonenstrahlung also besonders effizient.
Gemäß zumindest einer Ausführungsform der organischen Leuchtdiode beträgt ein mittlerer Abstand zwischen der ersten Elektrode und der aktiven Schicht zwischen einschließlich 15 nm und 100 nm, bevorzugt zwischen einschließlich 25 nm und 50 nm. Um die Ankopplung an die Oberflächenplasmonen zu reduzieren, ist in organischen Leuchtdioden ohne einer wie angegeben gestalteten Indexschicht der Abstand zwischen der ersten Elektrode und der aktiven Schicht im Regelfall möglichst groß gewählt. Möglichst groß bedeutet hierbei, dass der Abstand beispielsweise 100 nm übersteigt. Da über die Indexschicht eine Umwandlung der Oberflächenplasmonen in die Plasmonenstrahlung ermöglicht ist, ist der Abstand zwischen der aktiven Schicht und der ersten Elektrode reduzierbar.

Gemäß zumindest einer Ausführungsform der organischen Leuchtdiode beträgt ein mittlerer Abstand zwischen der ersten Elektrode und der aktiven Schicht höchstens 25 nm, insbesondere höchstens 15 nm. Durch einen derart geringen Abstand zwischen der aktiven Schicht und der ersten Elektrode ist eine besonders effiziente Ankopplung der in der aktiven Schicht erzeugten Strahlung an die Oberflächenplasmonenmoden der ersten Elektrode gewährleistbar. Mit anderen Worten wird ein besonders hoher Anteil der Leistungsaufnahme der organischen Leuchtdiode in Oberflächenplasmonen in mindestens der ersten Elektrode umgewandelt.

Gemäß zumindest einer Ausführungsform der organischen Leuchtdiode ist eine mittlere geometrische Gesamtdicke der organischen Schichtenfolge kleiner oder gleich 150 nm, bevorzugt kleiner oder gleich 90 nm. Eine derart geringe Gesamtdicke der organischen Schichtenfolge ist ermöglicht durch die Rückgewinnung der Oberflächenplasmonen in die Plasmonenstrahlung, sodass die Gesamteffzienz der Leuchtdiode aufgrund der Anregung der Oberflächenplasmonen den Wirkungsgrad der Leuchtdiode nicht oder nicht signifikant mindert.

Durch die geringe Schichtdicke der organischen Schichtenfolge verbessern sich weiterhin die elektrischen Eigenschaften der organischen Leuchtdiode. So fällt an der organischen Schichtenfolge, aufgrund deren geringer Dicke, auch nur eine geringere elektrische Spannung ab. Weiterhin ist der Materialeinsatz, der zum Erzeugen der organischen Schichtenfolge notwendig ist, reduzierbar. Außerdem wirkt die organische Schichtenfolge nicht mehr oder zumindest weit weniger als bei herkömmlichen Leuchtdioden als Wellenleiterschicht. Wirkt die organische Schichtenfolge nicht oder reduziert als Wellenleiterschicht, so kann sich eine Auskoppeleffizienz der erzeugten Strahlung erhöhen.

Gemäß zumindest einer Ausführungsform der organischen Leuchtdiode beträgt eine mittlere Abstrahlungsintensität der von der Leuchtdiode erzeugten Strahlung an der Rückseite der Leuchtdiode mindestens 5 %, insbesondere mindestens 15 %, einer mittleren Strahlungsintensität an der Vorderseite der Leuchtdiode. Mit anderen Worten wird ein signifikanter Anteil der von der Leuchtdiode emittierten Strahlungsleistung an der Rückseite, also an der der organischen Schichtenfolge abgewandten Seite der Leuchtdiode, emittiert.

Gemäß zumindest einer Ausführungsform der organischen Leuchtdiode entspricht, mit einer Toleranz von 25 Prozentpunkten, die mittlere Strahlungsintensität an der Rückseite der mittleren Strahlungsintensität an der Vorderseite. Bevorzugt beträgt die Toleranz höchstens 10 Prozentpunkte, insbesondere ist die mittlere Strahlungsintensität an der Rückseite und an der Vorderseite im Rahmen der Herstellungstoleranzen gleich. Das Verhältnis der Abstrahlungsintensitäten an der Vorderseite und an der Rückseite lässt sich zum Beispiel einstellen durch den Abstand zwischen der aktiven Schicht und der ersten Elektrode, also zwischen dem Ankopplungsgrad an die Oberflächenplasmonenmoden, und durch die Dicke und/oder Transparenz der metallischen ersten Elektrode. Es ist also eine organische Leuchtdiode mit insbesondere genau einer metallischen Elektrode realisierbar, die beidseitig, also an der Vorderseite und an der Rückseite, gleichmäßig Licht abstrahlt.

Bei der organischen Leuchtdiode gemäß der Erfindung beträgt der mittlere Brechungsindex der Indexschicht mindestens ein 1,2-faches, insbesondere mindestens ein 1,3-faches des mittleren Brechungsindexes der organischen Schichtenfolge. Durch den vergleichsweise großen Brechungsindexunterschied ist eine effiziente Generierung der Plasmonenstrahlung aus den Oberflächenplasmonen gewährleistbar.
Gemäß zumindest einer Ausführungsform der organischen Leuchtdiode ist die Indexschicht aus alternierend angeordneten Schichten gebildet, wobei die alternierend angeordneten Schichten jeweils unterschiedliche Materialzusammensetzungen aufweisen. Die alternierend angeordneten Schichten können beispielsweise abwechselnd einen vergleichsweise hohen und einen vergleichsweise niedrigen Brechungsindex aufzeigen.
Gemäß zumindest einer Ausführungsform der organischen Leuchtdiode ist mindestens eine der alternierend angeordneten Schichten mit einem Metalloxid gestaltet, das transparent ist. Beispielsweise ist die Indexschicht aus einer abwechselnden Abfolge von ZnO-Schichten und TiO-Schichten und/oder SrTiO₃-Schichten gebildet. Die Schichten sind zum Beispiel jeweils über Atomlagendeposition, englisch atomic layer deposition oder kurz ALD, hergestellt. Eine derart gestaltete Indexschicht weist einen hohen Brechungsindex und eine hohe Transparenz auf und ist weiterhin zur Versiegelung der organischen Leuchtdiode gegen äußere Einflüsse wie Sauerstoff und Feuchtigkeit geeignet.

Gemäß zumindest einer Ausführungsform der organischen Leuchtdiode ist deren Rückseite durch die Indexschicht gebildet. Das heißt, eine Lichtauskopplung aus der organischen Leuchtdiode an der Rückseite erfolgt direkt aus der Indexschicht heraus.

Gemäß zumindest einer Ausführungsform der organischen Leuchtdiode weist die Indexschicht eine Strukturierung zur Erhöhung einer Strahlungsauskopplung der Plasmonenstrahlung auf. Die Strukturierung kann regelmäßig oder auch unregelmäßig gestaltet sein. Beispielsweise ist die Strukturierung durch ein Ätzen mit einer Ätzmaske oder durch einen statistischen Aufrauprozess, wie beispielsweise ein Schleifen oder ein Sandstrahlen, erzeugt.

Gemäß zumindest einer Ausführungsform der organischen Leuchtdiode ist der Indexschicht ein Diffusionsmittel beigegeben. Das Diffusionsmittel ist zum Beispiel durch Streupartikel gebildet. Mit anderen Worten durchläuft die Plasmonenstrahlung oder wenigstens ein Teil der Plasmonenstrahlung die Indexschicht nicht geradlinig, sondern erfährt durch das Diffusionsmittel wenigstens eine Richtungsänderung, insbesondere durch Reflexion und/oder Streuung. Durch die Verwendung eines Diffusionsmittel ist, insbesondere in Kombination mit einer Strukturierung der Indexschicht, eine hohe Lichtauskoppeleffizienz bezüglich der Plasmonenstrahlung erzielbar.

Gemäß zumindest einer Ausführungsform der organischen Leuchtdiode beinhaltet die Indexschicht ein Konversionsmittel. Das Konversionsmittel ist hierbei dazu eingerichtet, wenigstens einen Teil der Plasmonenstrahlung zu absorbieren und in eine Strahlung mit einer größeren Wellenlänge umzuwandeln. Durch das Konversionsmittel kann auch eine räumliche Abstrahlcharakteristik der Leuchtdiode an der Rückseite verändert, insbesondere gleichmäßiger gestaltet werden. Das Konversionsmittel kann auch in Kombination mit dem Diffusionsmittel und mit der Strukturierung der Indexschicht eingesetzt werden.

Bei der organischen Leuchtdiode gemäß der Erfindung ist die zweite Elektrode mit einem transparenten leitfähigen Oxid geformt. Bevorzugt übersteigt die Dicke der zweiten Elektrode dann 100 nm, insbesondere 200 nm. Bevorzugt liegt die Dicke der zweiten Elektrode zwischen einschließlich 100 nm und 140 nm. Zum Beispiel ist die zweite Elektrode mit oder aus Indiumoxid, Indium-Zinnoxid, Indium-Zinkoxid, Zinkoxid oder Zinnoxid geformt. Ebenso ist als Material für die zweite Elektrode Al-dotiertes Zinkoxid, kurz AZO, einsetzbar.

Gemäß zumindest einer Ausführungsform der organischen Leuchtdiode weist mindestens die erste Elektrode entlang wenigstens einer Haupterstreckungsrichtung, bevorzugt entlang von zwei Haupterstreckungsrichtungen, eine Dickenvariation auf. Mit anderen Worten ändert sich die Dicke der ersten Elektrode beispielsweise periodisch oder statistisch verteilt entlang der zwei orthogonalen Haupterstreckungsrichtungen.

Gemäß zumindest einer Ausführungsform der organischen Leuchtdiode weist ein Träger des Leuchtdiode an einer Hauptseite eine Strukturierung auf. Auf diese Hauptseite des Trägers sind dann die erste und die zweite Elektrode sowie die organische Schichtenfolge und die Indexschicht, jeweils bevorzugt mit einer über die gesamte Hauptseite hinweg im Rahmen der Herstellungstoleranzen konstanten Dicke, aufgebracht.

Gemäß zumindest einer Ausführungsform der organischen Leuchtdiode liegt eine Längenskala der Dickenvariation und/oder der Strukturierung zwischen einschließlich 300 nm und 1,5 µm, bevorzugt zwischen einschließlich 400 nm und 1,0 µm. Die Dickenvariation kann hierbei eine gleichmäßige oder periodische Variation sein, die beispielsweise sinusförmig oder stufenförmig erfolgt und eine Periodizität entsprechend der Längenskala aufzeigt. Ebenso ist es möglich, dass die Dickenvariation in Form von Löchern in der ersten Elektrode, die in einem regelmäßigen Abstand zueinander angeordnet sind, ausgeführt ist. Auch kann es sein, dass die Längenskala eine mittlere Längenskala ist und die Dickenvariation entlang der Haupterstreckungsrichtungen unregelmäßig oder zufällig ist. Gemäß zumindest einer Ausführungsform der organischen Leuchtdiode befindet sich an einer der ersten Elektroden abgewandten Seite der Indexschicht ein Spiegel, der dazu eingerichtet ist, die Plasmonenstrahlung hin zur organischen Schichtenfolge zu reflektieren. Durch die Verwendung eines solchen Spiegels ist es möglich, dass die gesamte von der organischen Leuchtdiode erzeugte Strahlung über die Vorderseite aus der organischen Leuchtdiode ausgekoppelt wird. Bei Verwendung eines solchen Spiegels weist die Indexschicht bevorzugt ein Diffusionsmittel und/oder eine Strukturierung auf.

Gemäß zumindest einer Ausführungsform der organischen Leuchtdiode ist der Spiegel ein Teil der Indexschicht. Beispielsweise ist der Spiegel dann als Bragg-Spiegel geformt und die Spiegelschichten sind gleichzeitig Teilschichten der Indexschicht. Hierdurch ist eine effiziente Verkapselung und/oder ein kompakter Aufbau der organischen Leuchtdiode erzielbar.

Nachfolgend wird eine hier beschriebene organische Leuchtdiode unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt. Vielmehr können einzelne Elemente zum besseren Verständnis übertrieben groß dargestellt sein.

Es zeigen:
Figuren 1 bis 12 schematische Schnittdarstellungen von Ausführungsbeispielen von hier beschriebenen organischen Leuchtdioden,
Figur 13 eine schematische Schnittdarstellung einer Prinzipskizze, und
Figur 14 eine schematische Darstellung von Dispersionsrelationen von Oberflächenplasmonen.

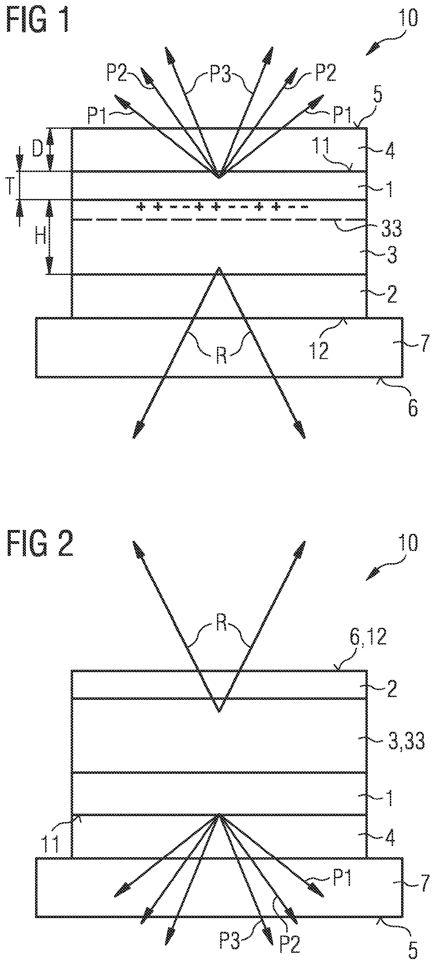

In Figur 1 ist ein Ausführungsbeispiel einer organischen Leuchtdiode 10 dargestellt. Die Leuchtdiode 10 weist eine organische Schichtenfolge 3 mit einer aktiven Schicht 33 auf. Im Betrieb der Leuchtdiode 10 wird in der aktiven Schicht 33 eine elektromagnetische Strahlung R erzeugt. Eine Gesamtdicke H der organischen Schichtenfolge 33 beträgt beispielsweise höchstens 300 nm, insbesondere höchstens 90 nm. An einer einem Träger 7 zugewandten Seite der Schichtenfolge 3 befindet sich eine zweite Elektrode 2. Die zweite Elektrode 2 ist mit einem transparenten leitfähigen Oxid gestaltet. Durch die zweite Elektrode 2 und den Träger 7 hindurch wird mindestens ein Teil der in der aktiven Schicht 33 erzeugten Strahlung R an einer Vorderseite 6 der Leuchtdiode 10 emittiert.
An einer dem Träger 7 abgewandten Seite der organischen Schichtenfolge 3 befindet sich eine erste Elektrode 1, die mit einem Metall, beispielsweise mit Silber, geformt ist. Durch die Strahlungserzeugung in der aktiven Schicht 33 sind an der Grenzfläche zwischen der ersten Elektrode 1 und der aktiven Schichtenfolge 3 Oberflächenplasmonen +, - angeregt. Diese Oberflächenplasmonen +, - können an eine der organischen Schichtenfolge 3 abgewandte Außenseite 11 der ersten Elektrode 1 gelangen. Um dies effizient zu ermöglichen, beträgt eine Dicke D der ersten Elektrode 11 bevorzugt zwischen einschließlich 25 nm und 50 nm.

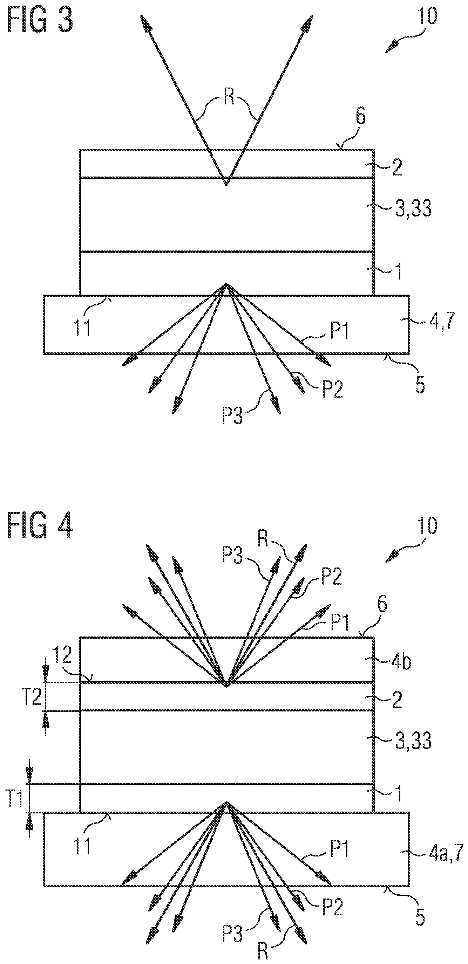

An der Außenseite 11 der ersten Elektrode 1 ist, in direktem Kontakt zur ersten Elektrode 1, eine Indexschicht 4 aufgebracht. Ein mittlerer Brechungsindex der Indexschicht 4 ist hierbei mindestens größer als ein mittlerer Brechungsindex der organischen Schichtenfolge 3. Durch die Indexschicht 4 ist auch eine Rückseite 5 der Leuchtdiode 10 gebildet.
Dadurch, dass der mittlere Brechungsindex der Indexschicht 4 größer ist als der mittlere Brechungsindex der organischen Schichtenfolge 3 ist es ermöglicht, dass die Oberflächenplasmonen +, - in der ersten Elektrode 1 in eine Plasmonenstrahlung P1, P2, P3 umgewandelt werden. Die Plasmonenstrahlung P1, P2, P3 durchläuft mindestens teilweise die Indexschicht 4 und wird von der Leuchtdiode 10 an der Rückseite 5 emittiert. Eine Dicke D der Indexschicht 4 beträgt hierbei mindestens 200 nm.
Aufgrund der Impulserhaltung und der Energieerhaltung bei der Umwandlung der Oberflächenplasmonen +, - in die Plasmonenstrahlung P1, P2, P3 erfolgt die Emission der Plasmonenstrahlung P1, P2, P3 bezüglich der Wellenlänge winkelabhängig. Eine Wellenlänge der Plasmonenstrahlung P1 ist also kleiner als eine Wellenlänge der Plasmonenstrahlung P2, die wiederum kleiner ist als eine Wellenlänge der Plasmonenstrahlung P3. Je kleiner die Wellenlänge der Plasmonenstrahlung P1, P2, P3 ist, desto kleiner ist also ein Winkel, in dem die Plasmonenstrahlung P1, P2, P3 zu einer Haupterstreckungsrichtung der ersten Elektrode 1 durch die Indexschicht 4 verläuft.
Beim Ausführungsbeispiel gemäß Figur 2 befindet sich die Indexschicht 4 zwischen dem Substrat 7 und der ersten Elektrode 1. Die Rückseite 5 ist durch das Substrat 7 gebildet und die Vorderseite 6 durch eine der organischen Schichtenfolge 3 abgewandte Außenseite 12 der zweiten Elektrode 2. Die Plasmonenstrahlung P1, P2, P3 wird durch das Substrat 7 hindurch aus der Leuchtdiode 10 emittiert.
Anders als in den Figuren 1 oder 2 dargestellt, kann das Substrat 7 eine Aufrauung zur Verbesserung der Auskoppeleffizienz aufweisen.
Gemäß Figur 3 bildet das Substrat 7 selbst die Indexschicht 4 aus. Das Substrat 7 ist also mit einem Material gestaltet, das einen Brechungsindex aufweist, der größer ist als der mittlere Brechungsindex der organischen Schichtenfolge 3. Bevorzugt beträgt eine Brechungsindexdifferenz zwischen der organischen Schichtenfolge 3 und dem Substrat 7 mindestens 0,2 oder mindestens 0,3. Zum Beispiel beträgt der Brechungsindex des Substrats 7 dann zirka 2,1 und der mittlere Brechungsindex der organischen Schichtenfolge 3 zirka 1,8, insbesondere mit einer Toleranz von jeweils 0,1 oder 0,05.
Die organische Leuchtdiode 10 gemäß Figur 4 ist als Mikroresonator-Leuchtdiode ausgeführt. Sowohl die erste Elektrode 1 als auch die zweite Elektrode 2 sind jeweils aus einem Metall geformt, beispielsweise jeweils aus Silber. Bevorzugt jedoch weisen die Elektroden 1, 2 voneinander verschiedene Metalle auf oder bestehen aus verschiedenen Metallen. Sowohl an der Außenseite 11 der ersten Elektrode 1 als auch an der Außenseite 12 der zweiten Elektrode 2 befinden sich die Indexschichten 4a, 4b. Optional ist es möglich, dass die Indexschicht 4a an der ersten Elektrode 1 gleichzeitig den Träger 7 darstellt.

Die Dicken D1, D2 der ersten Elektrode 1 und der zweiten Elektrode 2 sind so einstellbar, dass sowohl die Oberflächenplasmonen und somit eine Plasmonenstrahlung P1, P2, P3 generiert wird, als auch dass die direkt in der aktiven Schicht 3 erzeugte Strahlung R zumindest eine der Elektroden 1, 2 wenigstens zum Teil durchlaufen kann. Hierdurch ist es erzielbar, wie auch in den Ausführungsbeispielen gemäß etwa der Figuren 1 bis 3, dass sowohl an der Vorderseite 6 als auch an der Rückseite 5 der Leuchtdiode 10 nahezu gleich hohe Abstrahlungsintensitäten realisiert werden können.

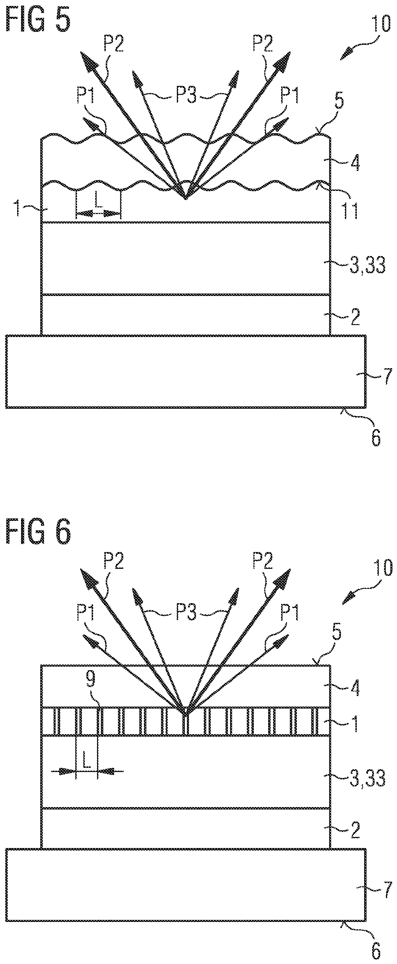

Gemäß dem Ausführungsbeispiel nach Figur 5 weist die erste Elektrode 1 entlang einer Haupterstreckungsrichtung eine Dickenvariation mit einer Längenskala L auf. Die Längenskala L liegt hierbei bevorzugt in der Größenordnung der Vakuumwellenlänge der emittierten Plasmonenstrahlung P1, P2, P3. Beispielsweise zeigt die Dickenvariation einen periodischen, sinusartigen Verlauf auf.

Optional kann auch die Indexschicht 4, anders als in Figur 5 dargestellt, eine Dickenvariation aufzeigen. Ebenso ist es möglich, abweichend von der Darstellung in Figur 5, dass die zweite Elektrode 2 eine Dickenvariation aufweist und die von der zweiten Elektrode 2 aus gesehen dem Substrat 7 abgewandten Schichten 3-5 mit einer konstante Dicke vorliegen. Auch kann eine der organischen Schichtenfolge 3 zugewandte Seite des Substrats 7 strukturiert sein, wobei dann bevorzugt die weiteren Schichten 2-5 eine konstante Dicke aufweisen.

Durch die Dickenvariation auf der Längenskala L der Wellenlänge der Plasmonenstrahlung P1, P2, P3 ist eine Art optisches Gitter an der ersten Elektrode 1 erzeugbar. Hierdurch ist es möglich, eine Winkelabhängigkeit der emittierten Plasmonenstrahlung P1, P2, P3 einzustellen. Beispielsweise übersteigt die Intensität der Plasmonenstrahlung P2 die Intensitäten der Plasmonenstrahlungen P1, P3.

Zur Vereinfachung der grafischen Darstellung ist in Figur 5 und in den folgenden Figuren die direkt in der aktiven Schicht 33 erzeugte Strahlung R nicht dargestellt.

Gemäß Figur 6 weist die erste Elektrode 1 Löcher 9 auf. Die Löcher 9 durchdringen die erste Elektrode 1 beispielsweise vollständig und können durch einen fotolithografischen Prozess erzeugt sein. Ein Durchmesser der Löcher 9 beträgt beispielsweise zwischen einschließlich 100 nm und 200 nm. Durch die Löcher 9 in der ersten Elektrode 1 ist ebenfalls eine Art optisches Gitter zur Einstellung der Abstrahlcharakteristik an der Rückseite 5 erzeugbar.

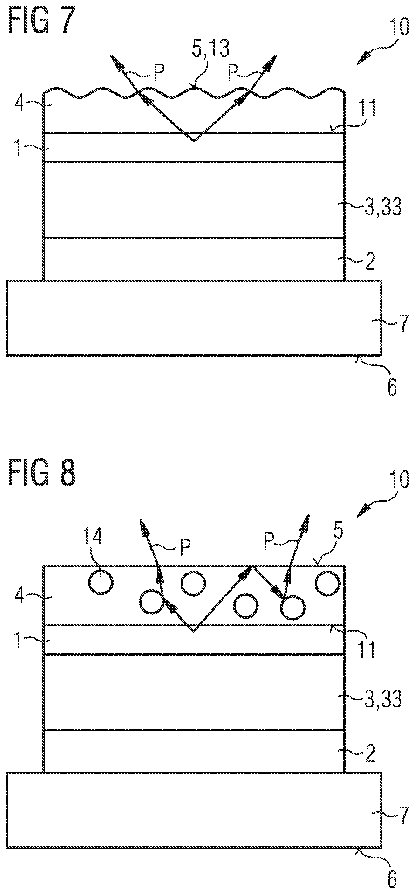

In Figur 7 ist illustriert, dass die Indexschicht 4 bevorzugt eine Strukturierung 13 zur Erhöhung der Auskoppeleffizienz der Plasmonenstrahlung P aufweist.

Gemäß Figur 8 umfasst die Indexschicht 4 ein Diffusionsmittel 14 in Form von Streupartikeln. Durch die Streupartikel 14 durchläuft die Plasmonenstrahlung P die Indexschicht 4, wenigstens zum Teil, nicht geradlinig, sondern wird an den Streupartikeln abgelenkt oder reflektiert. Hierdurch ist ebenfalls eine Auskoppeleffizienz der Plasmonenstrahlung P aus der Indexschicht 4 steigerbar.

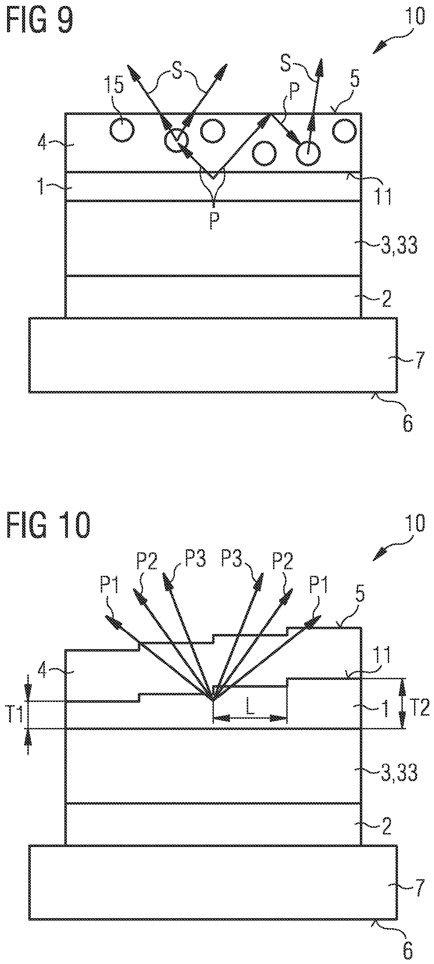

Beim Ausführungsbeispiel gemäß Figur 9 ist der Indexschicht 4 ein Konversionsmittel 15 beigegeben. Durch Partikel des Konversionsmittels 15 wird zumindest ein Teil der Plasmonenstrahlung P absorbiert und in eine Sekundärstrahlung S mit einer größeren Wellenlänge umgewandelt. Durch die Verwendung des Konversionsmittels 15 kann eine Abstrahlcharakteristik der emittierten Strahlung P, S homogenisiert, also gleichmäßiger gestaltet werden. Das Konversionsmittel 15 kann derart gewählt sein, dass beispielsweise nur ein blauer und grüner Spektralanteil der Plasmonenstrahlung in die Sekundärstrahlung S umgewandelt wird und etwa ein roter Anteil der Plasmonenstrahlung P unkonvertiert an der Rückseite 5 emittiert wird.

Gemäß Figur 10 zeigt die erste Elektrode 1 eine stufenartige Dickenvariation auf. Durch die Dickenvariation ist es erzielbar, dass an unterschiedlichen Stellen der ersten Elektrode 1 für verschiedene Wellenlängen der Plasmonenstrahlung P1, P2, P3 unterschiedliche Effizienzen für die Umwandlungen der Oberflächenplasmonen in die Plasmonenstrahlung P1, P2, P3 vorliegen. Durch die Dickenvariation der ersten Elektrode 1 ist hiernach, auch ohne Strukturierung der ersten Elektrode 1 nach Art eines optischen Gitters, eine Beeinflussung und Gestaltung der Abstrahlcharakteristik an der Rückseite 5 ermöglicht.

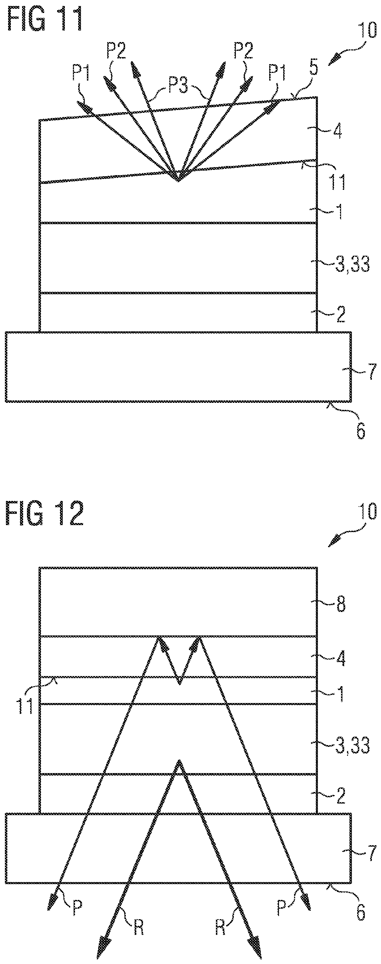

Beim Ausführungsbeispiel gemäß Figur 11 verläuft die Dickenvariation der ersten Elektrode 1 nicht stufenförmig, wie in Figur 10, sondern rampenartig. Wie auch in Figur 10 ist eine Periodizität der rampenartig gestalteten Dickenvariation bevorzugt größer als die Wellenlänge der Plasmonenstrahlung P1, P2, P3.

In Figur 12 ist ein Ausführungsbeispiel der Leuchtdiode 10 dargestellt, bei dem an einer der organischen Schichtenfolge 3 abgewandten Seite der Indexschicht 4 ein Spiegel 8 aufgebracht ist. Über den Spiegel 8 wird die Plasmonenstrahlung P in Richtung zum Substrat 7 hin reflektiert, sodass sowohl die Plasmonenstrahlung P als auch die direkt in der aktiven Schicht 33 erzeugte Strahlung R über die Vorderseite 6 aus der Leuchtdiode 10 emittiert werden. Bevorzugt weist die Indexschicht 4 hierbei ein in Figur 12 nicht gezeichnetes Streumittel auf. Weiterhin ist es möglich, dass der Spiegel 8 als ein Teil der Indexschicht 4 geformt ist.

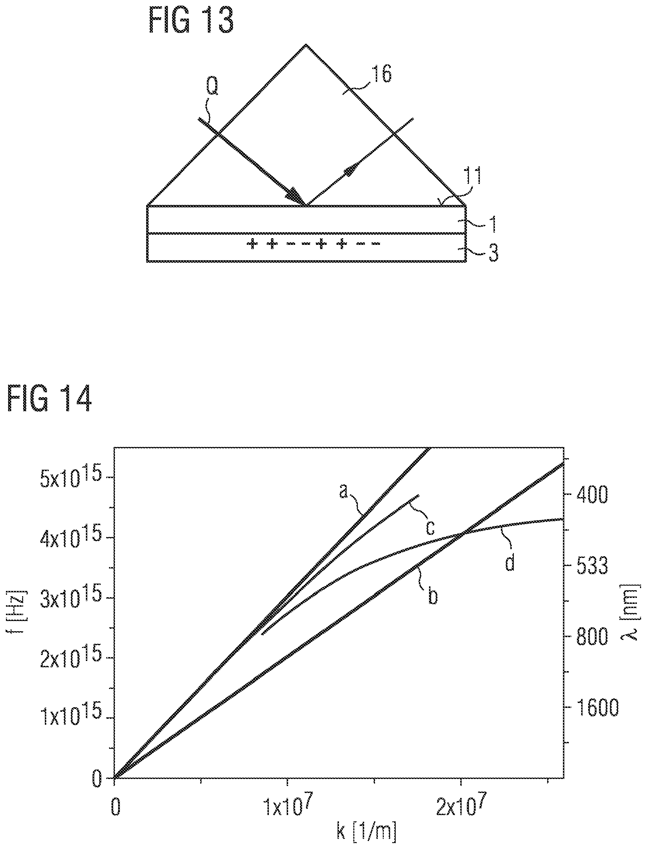

In Figur 13 ist eine so genannte Kretschmann-Konfiguration dargestellt. Ein Glasprisma 16 ist auf der ersten Elektrode 1 aufgebracht. An einer dem Glasprisma 16 abgewandten Seite der ersten Elektrode 1 ist ferner eine organische Schicht 3 aufgebracht. In das Glasprisma 16 wird eine Strahlung Q einer bestimmten Wellenlänge eingestrahlt. Abhängig von einem Einfallswinkel der Strahlung Q, einer Wellenlänge der Strahlung Q und den Brechungsindizes des Glasprismas 16 sowie der organischen Schicht 3 wird ein bestimmter Anteil der Strahlung Q in die Oberflächenplasmonen +, - umgewandelt. Es ist hierbei möglich, dass die gesamte Strahlung Q in Oberflächenplasmonen +, - umgewandelt wird. Im Vergleich zur organischen Leuchtdiode 10, etwa gemäß den Figuren 1 bis 12, liegt in der Kretschmann-Konfiguration also der umgekehrte Fall vor, es wird die Strahlung Q also in die Oberflächenplasmonen +, - umgewandelt.

In Figur 14 ist schematisch eine Dispersionsrelation der Oberflächenplasmonen +, - gezeigt. Aufgetragen ist hierbei ein Wellenvektor k in m⁻¹ gegen eine Wellenlänge λ in nm beziehungsweise eine Frequenz f in Hz. Eine Umwandlung der Strahlung Q in die Oberflächenplasmonen +, - ist bezüglich der Dispersionsrelation nur von einer weiter rechts liegenden Kurve auf eine weiter links liegende Kurve möglich.

Die Kurve a zeigt schematisch die Dispersionsrelation in Luft, die Kurve b die Dispersionsrelation in einem Medium mit Brechungsindex 1,5, die Kurve c die Dispersionsrelation für Oberflächenplasmonen an einer Luft-Silber-Grenzfläche und die Kurve d die Dispersionsrelation für Oberflächenplasmonen an einer Silber-Organik-Grenzfläche, wobei die Organik eine Dicke von zirka 30 nm aufweist.

Der umgekehrte Fall, also die Umwandlung von Oberflächenplasmonen +, - in eine Plasmonenstrahlung P ist hiernach nur dann möglich, wenn der Brechungsindex des Mediums, in dem die Oberflächenplasmonen in die Plasmonenstrahlung P umgewandelt werden, im vorliegenden Fall also der Indexschicht 4, hinreichend groß ist.

## Patentansprüche

1. Organische Leuchtdiode (10) mit
- einer ersten Elektrode (1), die mit einem Metall gebildet ist, und einer zweiten Elektrode (2),
- einer organischen Schichtenfolge (3) mit mindestens einer aktiven Schicht (33), wobei sich die organische Schichtenfolge (3) zwischen der ersten (1) und der zweiten Elektrode (2) befindet,
- einer Strahlung durchlässigen Indexschicht (4), die sich an einer der organischen Schichtenfolge (3) abgewandten Außenseite (11) der ersten Elektrode (1) befindet, und ein mittlerer Brechungsindex der Indexschicht (4) größer als ein mittlerer Brechungsindex der organischen Schichtenfolge (3) ist, und
- einer Vorderseite (6) und einer Rückseite (5), wobei die Rückseite (5) der Indexschicht (4) und die Vorderseite (6) der organischen Schichtenfolge (3) zugewandt ist und eine in der Leuchtdiode (10) erzeugte Strahlung (P, R, S) an der Vorderseite (6) und/oder an der Rückseite (5) emittiert wird,
wobei mindestens ein Teil einer von der organischen Leuchtdiode (10) erzeugten elektromagnetischen Plasmonenstrahlung (P) die Indexschicht (4) durchläuft und die Plasmonenstrahlung (P) wenigstens teilweise durch Oberflächenplasmonen erzeugt wird, die durch eine in der aktiven Schicht erzeugte elektromagnetische Strahlung mindestens an der Grenzfläche zwischen der ersten Elektrode (1) und der organischen Schichtenfolge (4) angeregt werden,
wobei die zweite Elektrode (2) mit einem transparenten leitfähigen Oxid geformt ist,
wobei der mittlere Brechungsindex der Indexschicht (4) mindestens ein 1,2-faches des mittleren Brechungsindexes der organischen Schichtenfolge (3) beträgt, und
wobei die Indexschicht (4) eine mittlere geometrische Dicke (D) von mindestens 200 nm aufweist und transparent, klarsichtig sowie dielektrisch gestaltet ist.

2. Organische Leuchtdiode (10) nach Anspruch 1,
bei der die Indexschicht (4) ein Metamaterial ist und TiO₂ enthält, das in einem Matrixmaterial eingebettet ist.

3. Organische Leuchtdiode (10) nach einem der vorhergehenden Ansprüche,
bei der die erste Elektrode (1) eine Dicke (T) zwischen einschließlich 25 nm und 65 nm aufweist.

4. Organische Leuchtdiode (10) nach einem der vorhergehenden Ansprüche,
bei der ein mittlerer Abstand (A) zwischen der ersten Elektrode (1) und der aktiven Schicht (33) zwischen einschließlich 15 nm und 80 nm beträgt und bei der eine mittlere geometrische Gesamtdicke (Z) der organischen Schichtenfolge (3) höchstens 150 nm beträgt.

5. Organische Leuchtdiode (10) nach den Ansprüchen 3 und 4,
bei der eine mittlere Abstrahlungsintensität der von der Leuchtdiode (10) erzeugten Strahlung (P, R) an der Rückseite (5) der Leuchtdiode (10) mindestens 5 % einer mittleren Abstrahlungsintensität an der Vorderseite (6) der Leuchtdiode (10) beträgt.

6. Organische Leuchtdiode (10) nach dem vorhergehenden Anspruch,
bei der, mit einer Toleranz von 25 Prozentpunkten, die mittlere Abstrahlungsintensität an der Rückseite (5) gleich der mittleren Abstrahlungsintensität an der Vorderseite (6) ist.

7. Organische Leuchtdiode (10) nach einem der vorhergehenden Ansprüche,
die ein Substrat (7) umfasst, auf dem die erste Elektrode (1), die zweite Elektrode (2) und die organische Schichtenfolge (3) angebracht sind, wobei das Substrat (7) selbst die Indexschicht (4) ausbildet.

8. Organische Leuchtdiode (10) nach einem der vorhergehenden Ansprüche,
bei der die Indexschicht (4) wenigstens zwei Arten alternierend angeordneter Schichten umfasst, wobei wenigstens eine Art der Schichten mit einem transparenten Metalloxid gestaltet ist.

9. Organische Leuchtdiode (10) nach einem der vorhergehenden Ansprüche,
bei der die Rückseite (5) durch die Indexschicht (4) gebildet ist und bei der die Indexschicht (4) eine Strukturierung (13) zur Erhöhung einer Strahlungsauskopplung der Plasmonenstrahlung (P) aufweist.

10. Organische Leuchtdiode (10) nach einem der vorhergehenden Ansprüche,
bei der die Indexschicht (4) ein Diffusionsmittel (14) beinhaltet,
wobei das Diffusionsmittel (14) durch Streupartikel gebildet ist.

11. Organische Leuchtdiode (10) nach zumindest Anspruch 8, bei der die Indexschicht (4) aus einer abwechselnden Abfolge von ZnO-Schichten und TiO-Schichten und/oder SrTiO₃-Schichten gebildet ist.

12. Organische Leuchtdiode (10) nach einem vorhergehenden Ansprüche,
bei der die erste Elektrode (1) Löcher (9) aufweist und die Löcher (9) die erste Elektrode (1) vollständig durchdringen,
wobei ein Durchmesser der Löcher (9) zwischen einschließlich 100 nm und 200 nm beträgt und durch die Löcher (9) in der ersten Elektrode (1) ein optisches Gitter zur Einstellung der Abstrahlcharakteristik an der Rückseite (5) erzeugt ist.

13. Organische Leuchtdiode (10) nach einem der vorhergehenden Ansprüche,
bei der die erste Elektrode (1) entlang mindestens einer Haupterstreckungsrichtung eine Dickenvariation aufweist, wobei eine Längenskala (L) der Dickenvariation mindestens 300 nm und höchstens 1,5 µm beträgt, und
wobei auch die Indexschicht (4) eine Dickenvariation aufweist.

14. Organische Leuchtdiode (10) nach zumindest Anspruch 10, bei der an einer der ersten Elektrode (1) abgewandten Seite der Indexschicht (4) ein Spiegel (8) angebracht ist, der dazu eingerichtet ist, die Plasmonenstrahlung (P) hin zur organischen Schichtenfolge (3) zu reflektieren, sodass sich die Indexschicht (4) zwischen dem Spiegel (8) und der metallischen ersten Elektrode (1) befindet,
wobei über den Spiegel (8) die Plasmonenstrahlung (P) in Richtung zu einem Substrat (7) hin reflektiert wird, sodass sowohl die Plasmonenstrahlung (P) als auch die direkt in der aktiven Schicht (33) erzeugte Strahlung (R) über die Vorderseite (6) aus der Leuchtdiode (10) emittiert werden.

## Claims

1. An organic light-emitting diode (10) comprising:
- a first electrode (1) which is formed with a metal, and a second electrode (2),
- an organic layer sequence (3) having at least one active layer (33) wherein the organic layer sequence (3) is located between the first electrode (1) and the second electrode (2),
- a radiation-transmissive index layer (4) which extends on an outer side (11) of the first electrode (1) facing away from the organic layer sequence (3), and an average refractive index of the index layer (4) is greater than an average refractive index of the organic layer sequence (3), and
- a front side (6) and a rear side (5), wherein the rear side (5) faces the index layer (4) and the front side (6) faces the organic layer sequence (3), and a radiation (P, R, S) generated in the light-emitting diode (10) is emitted at the front side (6) and/or on the rear side (5),
wherein at least part of a plasmon radiation generated by the organic light-emitting diode (10) passes through the index layer (4), and the plasmon radiation (P) is generated at least partially by surface plasmons, the surface plasmons are excited by an electromagnetic radiation generated in the active layer (33) at least at the interface between the first electrode (1) and the organic layer sequence (4),
wherein the second electrode (2) is formed with a transparent conductive oxide,
wherein the average refractive index of the index layer (4) is at least 1.2 times the average refractive index of the organic layer sequence (3), and
wherein the index layer (4) has a mean geometric thickness (D) of at least 200 nm and is configured transparent, clear and dielectrically.

2. The organic light-emitting diode (10) according to claim 1,
in which the index layer (4) is a metamaterial and contains TiO₂ which is embedded in a matrix material.

3. The organic light-emitting diode (10) according to one of the preceding claims,
in which the first electrode (1) has a thickness (T) between 25 nm and 65 nm inclusive.

4. The organic light-emitting diode (10) according to one of the preceding claims,
in which a mean distance (A) between the first electrode (1) and the active layer (33) is between 15 nm and 80 nm inclusive and in which a mean geometric overall thickness (Z) of the organic layer sequence (3) is at most 150 nm.

5. The organic light-emitting diode (10) according to claims 3 and 4,
in which an average emission intensity of the radiation (P, R) generated by the light-emitting diode (10) on the rear side (5) of the light-emitting diode (10) is at least 5% of a mean emission intensity at the front side (6) of the light-emitting diode (10).

6. The organic light-emitting diode (10) according to the preceding claim,
in which, with a tolerance of 25 percentage points, the average emission intensity at the rear side (5) is equal to the average emission intensity at the front side (6).

7. The organic light-emitting diode (10) according to one of the preceding claims,
which comprises a substrate (7) on which the first electrode (1), the second electrode (2) and the organic layer sequence (3) are attached,
wherein the substrate (7) itself forms the index layer (4).

8. The organic light-emitting diode (10) according to one of the preceding claims,
in which the index layer (4) comprises at least two types of alternately arranged layers, wherein at least one type of the layers is formed with a transparent metal oxide.

9. The organic light-emitting diode (10) according to one of the preceding claims,
in which the rear side (5) is formed by the index layer (4) and in which the index layer (4) has a structuring (13) for increasing a radiation coupling-out of the plasmon radiation (P) .

10. The organic light-emitting diode (10) according to one of the preceding claims,
in which the index layer (4) contains a diffusion agent (14), wherein the diffusion means (14) is formed by scattering particles.

11. The organic light-emitting diode (10) according to at least claim 8,
in which the index layer (4) is formed from an alternating sequence of ZnO layers and TiO layers and/or SrTiO₃ layers.

12. The organic light-emitting diode (10) according to one of the preceding claims,
in which the first electrode (1) has holes (9) and the holes (9) completely penetrate the first electrode (1),
wherein a diameter of the holes (9) is between 100 nm and 200 nm inclusive and through the holes (9) in the first electrode (1), an optical grating for setting the emission characteristic at the rear side (5) is realized.

13. The organic light-emitting diode (10) according to one of the preceding claims,
in which the first electrode (1) has a thickness variation along at least one main extension direction, wherein a length scale (L) of the thickness variation is at least 300 nm and at most 1.5 µm, and
wherein the index layer (4) also has a thickness variation.

14. The organic light-emitting diode (10) according to at least claim 10,
in which on the side of the index layer (4) facing away from the first electrode (1) a mirror (8) is mounted which is configured to reflect the plasmon radiation (P) towards the organic layer sequence (3) so that the index layer (4) is located between the mirror (8) and the metallic first electrode (1),
wherein the plasmon radiation (P) is reflected in the direction towards a substrate (7) via the mirror (8) so that the plasmon radiation (P) and the radiation (R) generated directly in the active layer (33) are emitted from the light-emitting diode (10) via the front side (6).

## Revendications

1. Diode électroluminescente organique (10) comprenant
- une première électrode (1) formée par un métal et une seconde électrode (2),
- une séquence de couches organiques (3) comportant au moins une couche active (33), la séquence de couches organiques (3) se trouvant entre les première (1) et seconde électrode (2),
- une couche d'indexation perméable au rayonnement (4) disposée sur une face extérieure (11) de la première électrode (3) opposée à la séquence de couches organiques (3), et un indice de réfraction moyen de la couche d'indexation (4) étant supérieur ou égal à un indice de réfraction moyen de la séquence de couches organiques (3), et
- une face avant (6) et une face arrière (5), la face arrière (5) étant orientée vers la couche d'indexation (4) et la face avant (6) étant orientée vers la séquence de couches organiques (3) et un rayonnement (P, R, S) généré dans la diode électroluminescente (10) étant émis sur la face avant (6) et/ou sur la face arrière (5),
au moins une partie d'un rayonnement plasmonique électromagnétique (P) généré par la diode électroluminescente organique (10) traversant la couche d'indexation (4) et le rayonnement plasmonique étant généré au moins partiellement par des plasmons de surface qui sont excités par un rayonnement électromagnétique généré dans la couche active au moins à l'interface entre la première électrode (1) et la séquence de couches organiques (4),
la seconde électrode étant constituée (2) par un oxyde transparent conducteur,
l'indice de réfraction moyen de la couche d'indexation (4) étant au moins 1,2 fois l'indice de réfraction moyen de la séquence de couches organiques (3), et
la couche d'indexation (4) ayant une épaisseur géométrique moyenne (D) d'au moins 200 nm et étant conçue sous forme transparente, translucide et diélectrique.

2. Diode électroluminescente organique (10) selon la revendication 1,
dans laquelle la couche d'indexation (4) est un métamatériau contenant du TiO₂ qui est noyé dans un matériau matriciel.

3. Diode électroluminescente (10) selon l'une des revendications précédentes,
dans laquelle la première électrode (1) présente une épaisseur (T) comprise entre 25 nm et 65 nm.

4. Diode électroluminescente (10) selon l'une des revendications précédentes,
dans laquelle un écart moyen (A) entre la première électrode (1) et la couche active (33) est compris entre 15 nm et 80 nm et dans laquelle une épaisseur géométrique totale moyenne (Z) de la séquence de couches organiques (3) est de 150 nm au maximum.

5. Diode électroluminescente selon les revendications 3 et 4, dans laquelle une intensité de rayonnement moyenne du rayonnement généré par la diode électroluminescente (10) sur la face arrière (5) de la diode électroluminescente (10) est d'au moins 5% d'une intensité de rayonnement moyenne sur la face avant (6) de la diode électroluminescente (10).

6. Diode électroluminescente (10) selon la revendication précédente,
dans laquelle l'intensité de rayonnement moyenne sur la face arrière (5) est égale à l'intensité de rayonnement moyenne sur la face avant (6), avec une tolérance de 25 points de pourcentage.

7. Diode électroluminescente (10) selon l'une des revendications précédentes,
comportant un substrat (7) sur lequel sont disposées la première électrode (1), la seconde électrode (2) et la séquence de couches organiques (3),
le substrat (7) formant lui-même la couche d'indexation (4) .

8. Diode électroluminescente (10) selon l'une des revendications précédentes,
dans laquelle la couche d'indexation (4) comprend au moins deux types de couches agencées en alternance, au moins un type des couches étant constitué par un oxyde métallique transparent.

9. Diode électroluminescente (10) selon l'une des revendications précédentes,
dans laquelle la face arrière (5) est constituée par la couche d'indexation (4) et dans laquelle la couche d'indexation (4) présente une structuration (13) pour augmenter un découplage de rayonnement du rayonnement plasmonique (P).

10. Diode électroluminescente (10) selon l'une des revendications précédentes,
dans laquelle la couche d'indexation (4) contient un agent de diffusion (14),
l'agent de diffusion (14) étant constitué par des particules vagabondes.

11. Diode électroluminescente organique (10) selon au moins la revendication 8,
dans laquelle la couche d'indexation (4) est constituée par une séquence alternante de couches ZnO et TiO et/ou SrTiO₃.

12. Diode électroluminescente organique (10) selon l'une des revendications précédentes,
dans laquelle la première électrode (1) présente des fentes (9), les fentes (9) traversant entièrement la première électrode (1),
un diamètre des fentes (9) étant compris entre 100 nm et 200 nm et un réseau de diffraction étant généré par les fentes (9) prévues dans la première électrode (1) pour mettre au point les caractéristiques de rayonnement sur la face arrière (5).

13. Diode électroluminescente (10) selon l'une des revendications précédentes,
dans laquelle la première électrode (1) présente, selon au moins une direction d'extension principale, une épaisseur variable, une gamme de longueurs (L) de l'épaisseur variable étant d'au moins 300 nm et de 1,5 µm au plus, et la couche d'indexation (4) présente également une épaisseur variable.

14. Diode électroluminescente organique (10) selon au moins la revendication 10,
dans laquelle un miroir (8) est monté sur une première face de la couche d'indexation (4) opposée à la première électrode (1) conçu pour refléter le rayonnement plasmonique (P) vers la séquence de couches organiques (3) de manière que la couche d'indexation (4) se trouve entre le miroir (8) et la première électrode métallique (1),
le rayonnement plasmonique (P) étant reflété par le miroir (8) en direction d'un substrat (7), de manière que le rayonnement plasmonique (P) ainsi que le rayonnement (R) généré directement dans la couche active (33) sont émis via la face avant (6) depuis la diode électroluminescente (10) .
